# EUROPÄISCHE PATENTSCHRIFT

(11) **EP 0 425 749 B1**
(45) Veröffentlichungstag und Bekanntmachung des Hinweises auf die Patenterteilung: **13.08.1997**
(21) Anmeldenummer: 89810816.2
(22) Anmeldetag: 31.10.1989
(51) Int. Cl.: H03K 17/28

(54) **Zeitrelais**
Timing relay
Relais temporisé

(43) Veröffentlichungstag der Anmeldung: 08.05.1991
(73) Patentinhaber: SAIA-Burgess Electronics AG, CH-3280 Murten (CH)
(72) Erfinder: Portmann, Urs, CH-3280 Murten (CH)
(74) Vertreter: Steiner, Martin

(56) Entgegenhaltungen:
- DE-A- 2 903 555
- GB-A- 2 159 646
- EDN ELECTRICAL DESIGN NEWS, Bd.29, Nr 17, 23.AUGUST 1984, SEITEN 236, 238, Boston, Massachusetts, US; R,LARSON: 'Cascading timers extend delay periods'
- PATENT ABSTRACTS OF JAPAN, Bd. 12, Nr. 420 (E-679)(3267), 8. November 1988;& JP-A-63157519
- PATENT ABSTRACTS OF JAPAN, Bd.11, Nr.59 (E-482)(2506)24. Februar 1984;& JP-A-61218218
- PATENT ABSTRACTS OF JAPAN, Bd.25, Nr.7(E-161)(1194) 25.Februar 1983;& JP-A-57199327
- H.ZANDER: "Analog-Digital-Wandler in der Praxis", 1983, MARKT & TECHNIK, Haar, Seiten 111, 112

## Beschreibung

Die vorliegende Erfindung betrifft ein Verfahren zur Bemessung eines Zeitabschnitts und ein Zeitrelais zur Durchführung dieses Verfahrens gemäss Oberbegriff des Anspruchs 1 bzw. 2. Ein Verfahren bzw. Zeitrelais dieser Art ist bekannt aus der GB-A-2 159 646. Der grosse Vorteil dieser Lösung besteht darin, dass das Verhältnis von Referenzspannung und Vergleichsspannung nicht vom Absolutwert der gemeinsamen Spannungsquelle abhängig und somit der der Zeitmessung zugrundeliegende Digitalwert am Ausgang des A/D-Wandlers von der analogen Spannungsquelle praktisch unabhängig ist. Die bekannte Schaltung arbeitet jedoch mit einem Mikroprozessor, was eine Integration erheblich erschwert. Der Hauptnachteil liegt aber darin, dass ein einmal ermittelter Digitalwert vom Ausgang des A/D-Wandlers für die Dauer der Zeitbemessung zugrundegelegt wird. Bei der A/D-Wandlung besteht jedoch eine gewisse Unsicherheit, d.h. der am Ausgang des A/D-Wandlers erscheinende Digitalwert kann bei gleichbleibenden Verhältnissen an den Eingängen des Wandlers zwischen benachbarten Werten hin und her springen. Besonders bei kleinen Werten kann daher das einmalige Erfassen des Momentanwertes zu einer erheblichen Abweichung vom richtigen Wert führen.

Ziel vorliegender Erfindung ist es, hier Abhilfe zu schaffen und eine einfacher integrierbare und genauere Lösung anzugeben. Diese Lösung ergibt sich aus den Kennzeichen der Ansprüche 1 und 2. Einmal geht es darum, den genannten Digitalwert nicht einmal zu erfassen, sondern laufend mit hoher Taktfrequenz in einen Speicher überzuführen, dessen Inhalt laufend ausgezählt wird. Diese als Zeitbasis dienende Auszählung beruht nun auf einem Mittelwert des Digitalwertes, womit der Einfluss zufälliger Abweichungen ausgeschaltet wird. Die Bemessung erfolgt ausschliesslich mit Hilfe einfacher Speicher und Zähler, womit die Integration der Schaltung vereinfacht ist.

Es ist zwar aus EDN ELECTRICAL DESIGN NEWS, Band 29, Nr. 17, Seiten 236, 238 bekannt, einen Zähler periodisch auszuzählen und nach jedem Zählvorgang einen Ausgangsimpuls an einen weiteren Zähler weiterzuleiten, wobei ein Zeitabschnitt durch Auszählen einer vorbestimmten Anzahl von Ausgangsimpulsen bestimmt wird. Andererseits ist es aus H. Zander "Analog-Digital-Wandler in der Praxis" 1983, MARKT & TECHNIK, Haar, Seiten 111, 112 auch bekannt, das Ergebnis eines A/D- Wandlers in einem Speicher bzw. Latch zwischenzuspeichern, während eine neue A/D-Wandlung erfolgt. Auch aus der Kombination dieser bekannten Lehren ergab sich jedoch nicht die beanspruchte Lösung, wonach zur Mittelwertbildung die A/D-Wandlung für ein und denselben Analogwert mehrfach durchgeführt und zwischengespeichert wird.

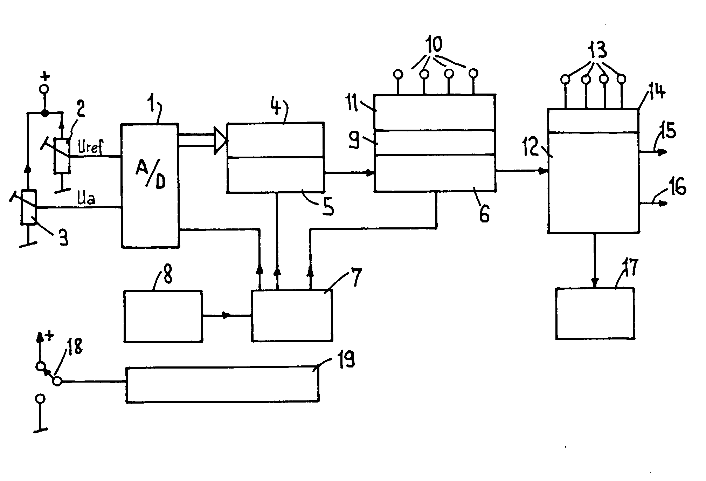

Die Erfindung wird nun anhand eines Ausführungsbeispiels näher erläutert, von welchem die Zeichnung ein Blockschema zeigt.

Die dargestellte Schaltung weist einen A/D-Wandler 1 auf, der zwei je mit einem Potentiometer 2 bzw. 3 verbundene Analogeingänge aufweist. Die beiden Potentiometer 2 und 3 werden aus ein und derselben Spannungsquelle (+) gespeist. Das Potentiometer 2 liefert eine Referenzspannung Uref und wird normalerweise schon beim Hersteller auf einen bestimmten festen Wert eingestellt, der einem bestimmten Anwendungszweck entspricht. Das potentiometer 2 kann auch wegfallen und durch einen festen Spannungsteiler ersetzt sein oder aber der Eingang des A/D-Wandlers für die Referenzspannung kann direkt mit der Spannungsquelle verbunden sein. Das Potentiometer 3 dient der Einstellung einer für die Zeitbemessung massgebenden Analogspannung Ua, die in einem bestimmten Bereich von einem Minimum bis zu einem Maximum gewählt werden kann. Im A/D-Wandler 1 wird laufend ein Digitalwert erzeugt, welcher dem Verhältnis zwischen der Analogspannung Ua und der Referenzspannung Uref entspricht.

Die dargestellte Schaltung weist einen Speicher 4 auf, der dazu dient, den digitalen Ausgangswert des A/D-Wandlers 1 zu speichern. Dazu wird der Speicher 4 periodisch mit relativ hoher Frequenz, z.B. der Oszillator-Taktfrequenz, mit dem A/D-Wandler verbunden. Damit wird der gespeicherte Wert stets unverzüglich dem Ausgangswert des Wandlers 1 bzw. dem analogen Eingangswert Ua angepasst. Dem Speicher 4 ist ein erster Zähler 5 zugeordnet, der mit dem Speicher 4 als Vorwärtszähler zusammenarbeitet und periodisch den Inhalt des Speichers 4 auszählt und bei jedem Nulldurchgang einen Ausgangsimpuls an einen zweiten Zähler 6 abgibt. Steuereingänge des A/D-Wandlers 1, des Zählers 5 und des Zählers 6 sind mit passenden Ausgängen eines Frequenzteilers 7 verbunden, dessen Eingang mit einem Quarzoszillator 8 verbunden ist. Mit passenden Steuerfrequenzen wird die periodische Wandlung des Analogwertes Ua in einen Digitalwert, die Zählgeschwindigkeit des Zählers 5 und die Zählgeschwindigkeit des Zählers 6 gesteuert. Es ist nun an sich klar, dass die Ausgangsfrequenz des ersten Zählers 5 abhängig ist von der soeben erwähnten an sich konstanten Zählfrequenz und dem jeweiligen Inhalt des Speichers 4. Nimmt man an, der Speicher 4 und der A/D-Wandler 1 hätten je eine Kapazität von 8 Bit, so können Digitalwerte zwischen 1 und 256 erzeugt bzw. gespeichert werden.

Dem zweiten Zähler 6 ist ein Speicher 9 zugeordnet, in welchen über geeignete Eingänge 10 und einen Decoder 11 ein bestimmter Wert eingegeben werden kann. Dieser Wert kann in einem sehr weiten Bereich varierbar sein, in dem der Speicher 9 und der Zähler 6 beispielsweise 18 Bit aufweisen. Jedesmal wenn der Zähler 6 beim Zählen des vorgewählten Wertes des Speichers 9 durch Null geht, wird ein Ausgangsimpuls an eine Funktionsmatrix 12 weitergeleitet, die mittels Eingängen 13 über einen Decoder 14 für bestimmte Funktionen eingestellt werden kann. Die Funktionsmatrix weist zwei Steuerausgänge 15 und 16 auf, über welche mindestens ein nachfolgendes Bauelement, z.B. Relais betätigt werden kann. Die Funktionsmatrix 12 ist mit einer Anzeige 17 verbunden, welche den Zustand des Zeitrelais (ausgeschaltet, Zeit ablaufend, einschaltverzögert, ausschaltverzögert, Ausgang geschaltet) anzeigt.

In der Regel wird das Zeitrelais durch Anlegen der Versorgungsspannung gestartet. Bei bestimmten Funktionen innerhalb der Funktionsmatrix 12 ist "Start" oder "Stop" nur über einen externen Steuerkontakt 18 möglich, der über die Steuereinheit 19 das Zeitrelais auszulösen gestattet. In diesen Fällen ist das Zeitrelais permanent mit der Versorgungsspannung verbunden.

Nach dieser allgemeinen Beschreibung des dargestellten Zeitrelais sei auf einige Besonderheiten des Aufbaus oder der Funktion hingewiesen. Der A/D-Wandler 1, der Speicher 4 und der Zähler 5 sind so gegenseitig verriegelt, dass der digitale Ausgangswert des Wandlers während der Abspeicherung im Speicher 4 sich nicht ändert. Andererseits erfolgt eine Ueberführung des Digitalwertes in den Speicher 4 nur zwischen aufeinanderfolgenden Zählvorgängen des Zählers 5. Für die oben erwähnten Bitzahlen des Speichers 4 bzw. Zählers 5, des Speichers 9 und des Zählers 6 kann eine Dauer von beispielsweise 10 ms bis 100 h vorgewählt werden. Die Bemessung der Dauer erfolgt hierbei so, dass mittels der Eingänge 10, des Decoders 11 und des Speichers 9 eine bestimmte Dauer, beispielsweise 1h, vorgewählt wird. Eine Stunde würde nun bemessen, wenn mittels des Potentiometers 3 der höchste Analogwert Ua eingestellt ist. Mittels dieses Potentiometers kann man nun denjenigen Teil der vorgewählten Dauer einstellen, welchen man wünscht. Man stellt also beispielsweise das Potentiometer anhand der ihm zugeordneten Skala auf 1/2 oder 1/4, um eine halbe oder eine viertel Stunde vorzuwählen. Dabei ist darauf zu achten, dass der niedrigsten einstellbaren Analogspannung Ua ein Digitalwert wesentlich grösser als 1, z.B. mindestens 10, entspricht, weil sonst die Abstufung zu grob und die Fehlerquelle zu gross wird. Mit anderen Worten ist die Analogspannung Ua nicht bis auf 0 einstellbar, sondern in einem Verhältnis von beispielsweise 1:25 zwischen einem Minimal- und einem Maximalwert.

## Patentansprüche

1. Verfahren zur Bemessung eines Zeitabschnittes, wobei einem A/D-Wandler (1) aus einer gemeinsamen Spannungsquelle eine analoge Referenzspannung (Uref) und über ein Potentiometer (3) eine analoge Vergleichsspannung (Ua) zugeführt wird und mittels des A/D-Wandlers ein Digitalwert erzeugt wird, welcher dem Verhältnis zwischen Vergleichsspannung und Referenzspannung entspricht, und wobei dieser Digitalwert zur Bestimmung des genannten Zeitabschnitts zugrundegelegt wird, dadurch gekennzeichnet, dass der genannte Digitalwert dauernd mit hoher Taktfrequenz in einen Speicher (4) übertragen wird und dass der Speicherinhalt periodisch ausgezählt und nach jedem Zählvorgang ein Ausgangsimpuls weitergeleitet wird, wobei der Zeitabschnitt durch Auszählen einer bestimmten Anzahl von Ausgangs impulsen bestimmt wird.

2. Zeitrelais zur Durchführung des Verfahrens nach Anspruch 1, mit einem A/D-Wandler (1) welchem aus einer gemeinsamen Spannungsquelle eine Referenzspannung (Uref) und über ein Potentiometer (3) eine analoge Vergleichsspannung (Ua) zugeführt wird, wobei der A/D-Wandler Ausgänge aufweist, an welchen ein dem Verhältnis zwischen Referenzspannung (Uref) und Vergleichsspannung (Ua) entsprechender Digitalwert erscheint, wobei ein Zähler (5) vorhanden ist, welcher eine vom genannten Digitalwert abhängige Auszählung vornimmt und wobei dieser Digitalwert zur Bestimmung eines zu bemessenden Zeitabschnittes zugrundegelegt wird, dadurch gekennzeichnet, dass dem A/D-Wandler ein Speicher (4) zugeordnet ist, in den der Digitalwert mit hoher Taktfrequenz laufend übertragen wird, dass der genannte Zähler (5) periodisch den Speicherinhalt auszählt und bei jedem Nulldurchgang einen Ausgangsimpuls weiterleitet, und dass mindestens ein weiterer Zähler (6) vorhanden ist, welcher eine einstellbare Zahl von Ausgangsimpulsen auszuzählen und damit den zu bemessenden Zeitabschnitt zu bestimmen in der Lage ist.

3. Zeitrelais nach Anspruch 2, dadurch gekennzeichnet, dass der Ausgang des weiteren Zählers (6) mit einer Funktionsmatrix (12) verbunden ist.

4. Zeitrelais nach Anspruch 2 oder 3, dadurch gekennzeichnet, dass der weitere Zähler (6) mit einem einstellbaren Speicher (9) verbunden ist, dessen Inhalt der Zähler jeweils auszählt.

5. Zeitrelais nach einem der Ansprüche 2 bis 4, gekennzeichnet durch eine Anzeige (17) zur Anzeige der Betriebszustände.

## Claims

1. Method for the measurement of a time interval, where an A/D converter (1) is supplied by a common voltage source with an analog reference voltage (Uref) and, though a potentiometer (3), with an analog comparative voltage (Ua), and a digital value is generated by means of the A/D converter which corresponds to the ratio of the comparative voltage and the reference voltage, said digital value being used in order to determine said time interval, characterised in that said digital value is continuously transmitted at a high clock frequency to a memory (4), and in that the content of the memory is periodically counted out and an output pulse is forwarded after each count, the time interval being determined by counting a determined number of output pulses.

2. Time lag relay for carrying out the method according to claim 1, comprising an A/D converter (I) which is supplied by a common voltage source with a reference voltage (Uref) and, through a potentiometer (3), with an analog comparative voltage (Ua), the A/D converter having outputs where a digital value corresponding to the ratio of the reference voltage (Uref) and the comparative voltage (Ua) appears, and a counter (5) being provided which performs a count which is a function of said digital value, and said digital value being used in order to determine a time interval which is to be measured, characterised in that the A/D converter has an associated memory (4) to which the digital value is continuously transmitted at a high clock frequency, in that the counter (5) periodically counts the content of the memory and forwards an output pulse at each passage through zero, and in that at least one additional counter (6) is provided which is capable of counting an adjustable number of output pulses and thus of determining the time interval which is to be measured.

3. Time lag relay according to claim 2, characterised in that the output of said additional counter (6) is connected to a function matrix (12).

4. Time lag relay according to claim 2 or 3, characterised in that said additional counter (6) is connected to an adjustable memory (9) whose momentary content is being counted by the counter.

5. Time lag relay according to any one of claims 2 to 4, characterised by a display (17) for the purpose of indicating its operational conditions.

## Revendications

1. Procédé de mesure d'un intervalle de temps où un convertisseur analogique-numérique (1) est alimenté par une source de tension commune d'une tension de référence analogique (Uref) et, par l'intermédiaire d'un potentiomètre (3), d'une tension analogique de comparaison (3), et une valeur digitale est générée au moyen du convertisseur analogique-numérique qui correspond au rapport entre la tension de comparaison et la tension de référence, ladite valeur digitale étant utilisée pour la mesure dudit intervalle de temps, caractérisé en ce que ladite valeur digitale est continuellement tranférée à haute cadence dans une mémoire (4), et que le contenu de la mémoire est périodiquement compté alors qu'une impulsion de sortie est transmise après chaque comptage, l'intervalle de temps étant déterminé par le comptage d'un nombre donné d'impulsions de sortie.

2. Relais à temporisation pour la mise en oeuvre du procédé selon la revendication 1, comprenant un convertisseur analogique-numérique (1) qui est alimenté par une source de tension commune d'une tension de référence (Uref) et, par l'intermédiaire d'un potentiomètre (3), d'une tension analogique de comparaison (Ua), le convertisseur analogique-numérique présentant des sorties auxquelles apparaît une valeur digitale qui correspond au rapport entre la tension de référence (Uref) et la tension de comparaison (Ua), et un compteur (5) étant pourvu qui effectue un comptage en fonction de ladite valeur digitale, cette valeur digitale étant utilisée pour déterminer un intervalle de temps à mesurer, caractérisé en ce qu'une mémoire (4) est associée au convertisseur analogique-numérique dans laquelle la valeur digitale est continuellement transférée à haute cadence, que ledit compteur (5) compte périodiquement le contenu de la mémoire et transmet une impulsion de sortie à chaque passage par zéro, et qu'au moins un compteur additionnel (6) est pourvu qui est capable de compter un nombre d'impulsions de sortie ajustable et de mesurer ainsi l'intervalle de temps à mesurer.

3. Relais à temporisation selon la revendication 2, caractérisé en ce que la sortie du compteur additionnel (6) est reliée à une matrice de fonctions (12).

4. Relais à temporisation selon la revendication 2 ou 3, caractérisé en ce que le compteur additionnel (6) est relié à une mémoire ajustable (9) dont le compteur compte chaque fois le contenu actuel.

5. Relais à temporisation selon l'une des revendications 2 à 4, caractérisé par un affichage (17) indiquant les conditions de fonctionnement.
